# EUROPÄISCHE PATENTSCHRIFT

(11) **EP 2 359 973 B1**
(45) Veröffentlichungstag und Bekanntmachung des Hinweises auf die Patenterteilung: **25.06.2014**
(21) Anmeldenummer: 11155362.4
(22) Anmeldetag: 22.02.2011
(51) Int. Cl.: B23K 1/06, B23K 3/06, B23K 1/00

(54) **Verfahren und Vorrichtung zum Aufbringen von Lot auf ein Werkstück**
Method and device for applying solder to a workpiece
Procédé et dispositif d'application de brasure sur une pièce

(30) Priorität: 23.02.2010 DE 102010000520
(43) Veröffentlichungstag der Anmeldung: 24.08.2011
(73) Patentinhaber: SCHOTT Solar AG, 55122 Mainz (DE)
(72) Erfinder: Von Campe, Hilmar, Dr., 61352 Bad Homburg (DE); Meyer, Stefan, 63549 Ronneburg (DE); Huynh-Minh, Thai, 63456 Hanau (DE); Huber, Stephan, 83562 Rechtmehring (DE); Reiff, Silvio, 63743 Aschaffenburg (DE)
(74) Vertreter: Stoffregen, Hans-Herbert

(56) Entgegenhaltungen:
- EP-A1- 1 195 217
- EP-A1- 1 699 090
- US-A- 3 222 776
- US-A1- 2005 205 641
- US-A1- 2009 155 958
- BACH F-W ET AL: "ULTRASCHALLASSISTIERTES FLAMMLOETEN VON ALUMIUMLEGIERUNGEN", SCHWEISSEN UND SCHNEIDEN, DVS VERLAG, DUSSELDORF, DE, Bd. 57, Nr. 9, 1. Januar 2005 (2005-01-01) , Seiten 482,484-487, XP001239432, ISSN: 0036-7184

## Beschreibung

Die Erfindung bezieht sich auf ein Verfahren zum Aufbringen von Lot auf ein Werkstück, vorzugsweise auf ein Halbleiterbauelement wie eine Solarzelle, wobei Lot bei einer Löttemperatur T_{L} unter Ultraschalleinwirkung aufgelötet wird. Ferner bezieht sich die Erfindung auf eine Vorrichtung zum Aufbringen und Auflöten eines Lots in einer Lötzone auf ein Werkstück, insbesondere Halbeiterbauelement wie Solarzelle, umfassend eine Lotzuführeinrichtung, eine Heizeinrichtung für das Lot, eine Ultraschallsonotrode sowie eine Transporteinrichtung zum Transport des Werkstücks relativ zu sowohl der Heizeinrichtung als auch der Ultraschallsonotrode.

Aus der WO-A-2008/014900 (DE-A-10 2006 035 626) ist ein Verfahren zum Anbringen eines Verbindungsleiters an einer Solarzelle bekannt, bei dem ein Lot mittels Ultraschalllöten auf die Solarzelle aufgebracht wird. Hierzu wird das Lot in Form eines Lotdrahts oder von Lotformteilen mittels einer Ultraschallsonotrode bei Löttemperatur aufgelötet.

Das Auflöten von Lot auf insbesondere Solarzellen mittels Ultraschall zeigt den Vorteil, dass ein Flussmittel nicht benutzt werden muss, wodurch anderenfalls die Gefahr einer Beschädigung der Solarzelle erwächst. Durch die Ultraschalleinwirkung werden auf den Solarzellen vorhandene Oxidschichten aufgebrochen, um eine mechanisch feste und elektrisch gut leitende Verbindung zwischen dem Lot und der entsprechenden Metallschicht der Solarzelle sicherzustellen. Dies ist insbesondere dann von Vorteil, wenn es sich bei der Metallschicht um eine Aluminiumschicht wie ein aus Aluminium bestehender Rückseitenkontakt handelt.

Entsprechende Ultraschalllötverfahren sind z. B. auch der US-B-6,357,649 oder der Literaturstelle Mardesich et al.: "A Low-Cost Photovoltaic Cell Process Based on Thick Film Techniques; 14th IEEE PV, Sp.Conf. Proc., 1980, Seiten 943 - 947, zu entnehmen.

Bei den bekannten Verfahren besteht der Nachteil, dass durch das Aufsetzen einer Ultraschall applizierenden Löteinrichtung, bei der es sich um eine Ultraschallsonotrode handeln kann, bei dünnen bruchempfindlichen Werkstücken eine Beschädigung dieser erfolgt. Insbesondere ist jedoch der Nachteil zu beobachten, dass dann, wenn das Werkstück eine unebene Oberfläche aufweist, die Lötverbindung nicht im erforderlichen Umfang gleichmäßig ausgebildet ist. Auch ist der Nachteil gegeben, dass durch das Aufschmelzen des Lotes durch von der Ultraschallsonotrode übertragene Wärmeenergie der benötigte Wärmeeintrag nicht im erforderlichen Umfang reproduzierbar aufgrund der Gestaltung der Sonotrode in ihrer Spitze, die mit dem Lot kontaktiert wird, erzielbar ist.

Aus der EP-A-1 699 090 sind ein Verfahren und eine Vorrichtung zur Herstellung von Solarzellenmodulen bekannt. Hierzu werden einzelne untereinander zu verbindende Solarzellen zwischen Transportbändern geführt, wobei ein Transportband die erforderliche Wärmeenergie zum Verbinden aufeinander folgender Solarzellen mit einem Verbinder abgibt und ein anderes Band den zum Verbinden erforderlichen Druck überträgt. Über ein drittes Transportband werden die Solarzellen den ersten beiden Bändern zugeführt.

Der JP-A-2844330 ist eine Ultraschallsonotrode zu entnehmen, über die Lot auf ein Werkstück aufgebracht wird. Die Längsachse der Ultraschallsonotrode verläuft parallel zur Normalen des Werkstücks.

In der DE-T-692 22 611werden Lotmaterialien beschrieben, die als Bestandteil Abriebmittel enthalten.

Der US-A-3,222,776 sind ein Verfahren und eine Vorrichtung zum Behandeln von geschmolzenem Lot zu entnehmen, um einen Draht mit einem Kontakt zu verlöten. Das Portionieren der aufzubringenden Lötmenge erfolgt mittels Ultraschall.

Ein Verfahren zum Löten unter Verwendung eines bleifreien Lotmaterials wird in der EP-A-1 195 217 beschrieben. Dabei kann eine elektronische Komponente mit einer Leiterplatte verbunden werden, die in Ultraschallschwingung versetzt wird.

Die Literaturstelle Bach F-W et al.: "Ultraschallisiertes Flammlöten von Alluminiumlegierungen", Schweissen und Schneiden, DVS Verlag, Düsseldorf, DE, beschäftigt sich mit dem ultraschallassistierten Flammlöten von Aluminiumlegierungen. Dabei kann eine Ultraschalleinkopplung im Bereich der Fügezone von massiven Bauteilen, und zwar direkt in das Lot, erfolgen.

Ein ultraschallunterstütztes Lötverfahren für LED-Chips ist aus der US-A-2009/155958 bekannt.

Um Bauelemente zu verschweißen, wird nach der US-A-2005/205641 ein Ultraschallwerkzeug benutzt.

Der vorliegenden Erfindung liegt die Aufgabe zu Grunde, ein Verfahren und eine Vorrichtung der eingangs genannten Art so weiterzubilden, dass problemlos auf bruchempfindliche Werkstücke ein Lot aufgelötet werden kann, insbesondere auf Werkstücke einer Dicke bis 200 µm und/oder welliger bzw. leicht gekrümmter Oberfläche. Dabei soll die Möglichkeit eines hohen Durchsatzes bei gleichzeitiger Sicherstellung reproduzierbarer Lötungen eröffnet werden.

Erfindungsgemäß wird die Aufgabe durch ein Verfahren der eingangs genannten Art im Wesentlichen dadurch gelöst, dass das Lot mittels einer Heizeinrichtung erwärmt wird, auf das Werkstück aufgebracht und unter Ultraschalleinwirkung aufgelötet wird, wobei das Werkstück während des Auflötens federnd durch Andrücken des Werkstücks in Richtung der Sonotrode mittels einer das Werkstück fördernden Transporteinrichtung gelagert wird.

Dabei ist insbesondre vorgesehen, dass das Lot nach dessen Erwärmen auf eine Lottemperatur TL mittels Ultraschalleinwirkung aufgelötet wird. Die Lottemperatur TL ist ≥ TM, wobei TM Schmelzpunkt des Lotmaterials ist. Dieser liegt z.B. bei einem Sn-Bi-Lotmaterial bei 140 °C und bei einem Sn-Pb Lotmaterial bei 180 °C.

Erfindungsgemäß ist insbesondere vorgesehen, dass das Lot zunächst auf eine gewünschte Löttemperatur erhitzt wird, um sodann das geschmolzene Lot auf das Werkstück aufzutragen. Sodann wird der gewünschte Ultraschall appliziert. Durch diese Maßnahmen ist ein reproduzierbares Auflöten oder Beloten sichergestellt, wobei das Erwärmen des Werkstücks zum stoffschlüssigen Verbinden mit dem Lot von diesem selbst unmittelbar in das Werkstück übertragen wird. Das erwärmte Lot selbst trägt die zu der Verbindung erforderliche Wärme in das Werkstoffmaterial ein, ohne dass eine Wärmeübertragung über die Ultraschalleinrichtung erfolgen muss. Hierdurch ist ein reproduzierbares Auflöten sichergestellt.

Insbesondere sieht die Erfindung vor, dass die Erwärmung des Werkstücks dadurch erfolgt, dass das Lot seine Wärme durch den Kontakt mit dem Werkstück an das Werkstück abgibt. Um dies sicherzustellen, kann die das Lotmaterial erhitzende Heizeinrichtung unmittelbar über das Werkstück im Bereich der Lötzone geführt werden, wobei gegebenenfalls ein unmittelbarer Kontakt zwischen der Heizeinrichtung und dem Werkstück z. B. mittels von der Heizeinrichtung ausgehenden Kufen erfolgt.

Ergänzend kann die Ultraschalleinrichtung auf die gewünschte Löttemperatur eingestellt werden. Ferner sollte die Temperatur der Sonotrode gleich oder geringfügig höher als die Lottemperatur T_{L} sein, sofern dem Lot keine Wärme entzogen werden soll.

Die Temperatur der Heizeinrichtung sollte vorzugsweise zwischen der Lottemperatur T_{L} und 600 °C, insbesondere im Bereich zwischen 300 °C und 500 °C liegen, insbesondere im Bereich von zumindest in etwa 100 °C oberhalb der Lottemperatur T_{L}.

Damit die Sonotrode Wärme dem Lot nicht entzieht, sollte die Temperatur der Sonotrode zwischen der Lottemperatur TL und 600 °C, vorzugsweise im Bereich zwischen 300 °C und 500 °C liegen. Bevorzugterweise weist die Sonotrode eine Temperatur auf, die gleich der der Heizeinrichtung ist.

In hervorzuhebender eigenerfinderischer Ausgestaltung ist des Weiteren vorgesehen, dass das Werkstück während des Verlötens federnd gelagert wird. Hierdurch ist sichergestellt, dass auch in ihrer Dicke variierende oder unebene Oberflächen aufweisende Werkstücke im erforderlichen Umfang und reproduzierbar prozessiert werden können. Es erfolgt ein federndes Andrücken des Werkstückes an die Ultraschallsonotrode, wobei sichergestellt ist, dass der Sonotrodenkopf bzw. dessen Spitze stets das aufgeschmolzene Lot während der Ultraschalleintragung kontaktiert.

Die federnde Lagerung des Werkstücks, aufgrund der das Werkstück in Richtung der Sonotrode gedrückt wird, wird durch ein Transportelement ermöglicht, mittels dessen das Werkstück unter der Sonotrode hindurch gefördert wird. Das Transportelement sollte dabei einen Elastizitätsmodul E in kN/mm² zwischen 0,01 kN/mm² ≤ E ≤ 0,1 kN/mm² aufweisen.

Durch all diese Maßnahmen können hochempfindliche Werkstücke wie Silizium-Wafer zerstörungsfrei prozessiert werden, wobei gleichzeitig sichergestellt ist, dass durch die Temperatureinstellung ungeachtet der Ultraschalleinwirkung Risse nicht auftreten.

Insbesondere ist vorgesehen, dass während des Lötprozesses das Werkstück über z. B. als Zahnriemen ausgebildete Transporteinrichtung in die Lötzone und durch diese hindurch transportiert wird. Das Lot in Form eines Drahtes kann über einen handelsüblichen Drahtvorschub in die Lötzone eingebracht werden. Hierzu kann der Lotdraht in eine Heizeinrichtung eingeschoben werden, in der das Lot schmilzt. Nachfolgender Lotdraht drückt das geschmolzene Material über eine Austrittsöffnung aus, damit das Lotmaterial auf das Werkstück aufgetragen wird. Hierbei kann bereits das geschmolzene Lotmaterial mit der Sonotrode in Berührung gelangen, die bevorzugterweise gleichfalls beheizt ist.

Das Beheizen der Sonotrode ist bei großen Auftragsflächen nicht zwingend erforderlich. Soll jedoch nach dem Aufbringen des Lots auf dieses z. B. eine Leiterbahn aufgelötet werden, wie dies im Falle von Verbindungsleitern bei Solarzellen als Werkstücken der Fall ist und somit schmale Lotstreifen aufgelötet werden, so würde beim Auflöten des Lotes dann, wenn nicht im hinreichenden Umfang eine konstante Temperatur eingehalten wird, nicht sichergestellt sein, dass die Abrisskräfte der Leiterbahn über die Leiterbahnlänge gleich bleibend ist. Dies ist insbesondere dann der Fall, wenn der Leiterbahnquerschnitt unterhalb von 5 mm² liegt.

Eine gleichmäßige Temperatur in der Lötzone wird erreicht, wenn man das Lot durch eine Heizeinrichtung fördert, die unmittelbar auf das Werkstück Wärme abstrahlt. Durch eine Metallplatte, die sich entlang des Werkstücks erstreckt, kann das Lot gefördert werden. Ausreichend leistungsstarke Heizelemente sind ebenfalls erforderlich. Heizelemente und Wärmekapazität sind so auszulegen, dass Schmelzwärme und Kristallisationswärme in kurzer Zeit zu- und abgeführt werden können. Dabei erfolgt erwähntermaßen die Zuführung der Schmelzwärme unabhängig von der Temperatur der Sonotrode, die gleichfalls beheizt sein kann.

Die Wärmeabfuhr sollte im Wesentlichen innerhalb des Werkstücks wie in einer Siliziumscheibe als Werkstück erfolgen, die die Wärme an die Umgebungsluft abführt. Die übertragende Wärme führt nur zu einer geringen Erwärmung der Siliziumscheibe selbst, so dass anschließend unmittelbar ein weiteres Prozessieren erfolgen kann.

Die erfindungsgemäße Lehre schließt aber auch die Möglichkeit ein, dass unmittelbar nach der Ultraschalleinwirkung auf das aufgelötete Lot ein Leiter wie Verbindungsleiter einer Solarzelle aufgelötet wird.

Es sollten Lot und Sonotrode an ein und derselben Stelle mit der Metallisierung der Solarzelle als Werkstück direkt in Berührung gebracht werden, wobei der Abstand a zwischen der Sonotrode und der Metallisierung betragen kann: 0 < a ≤ 500 µm, insbesondere 50 µm ≤ a ≤ 100 µm.

Erfindungsgemäß werden Ultraschallleistung und -frequenz, Lotzufuhr- und Löttemperatur unabhängig voneinander gesteuert oder geregelt, so dass ein zu Beschädigungen wie Bruch- und Rissbildung führendes Auflöten des Lots auf das Werkstück vermieden wird.

Dass bei dem erfindungsgemäßen Ultraschalllöten Risse insbesondere in einem Halbleiterbauelement wie Solarzelle nicht auftreten, wird über die sehr schonende Wärmezufuhr sichergestellt. Erfindungsgemäß erfolgt die Zuführung von Wärme über das erwärmte Lot selbst, gleichwenn das Halbleiterbauelement über eine Zusatzheizung beheizt werden kann, ohne dass dies zwingend erforderlich ist. Vielmehr ist insbesondere vorgesehen, dass die benötigte Prozesstemperatur ausschließlich über das erwärmte Lot aufgebracht wird. Eine Zusatzheizung kann dann vorgesehen sein, wenn gewünscht wird, dass die Abkühlung des Lots aufgrund der Wärmeleitung in dem Werkstück minimiert werden soll. Im Falle von Solarzellen ist zwar die Wärmekapazität und auch die Wärmeleitung aufgrund der geringeren Dicke, wie z. B. bis zu 200 µm, niedrig. Da jedoch zum späteren Auflöten von Verbindungsleitern auch nur relativ geringe Lotmengen aufgetragen werden, kann eine Zusatzheizung gegebenenfalls zur Anwendung gelangen, um reproduzierbare Ergebnisse sicherzustellen.

Die Erfindung wird jedoch auch dann nicht verlassen, wenn eine Zusatzheizeinrichtung benutzt wird, die zum einen zum Vorheizen des Halbleiterbauelementes und zum anderen zum Aufschmelzen bzw. Erhitzen des Lotmaterials dienen kann.

Hierzu kann z.B. eine Heißluftdüse verwendet wird, die die Solarzelle vorheizt bzw. das Lotmaterial aufschmilzt. In diesem Fall ist ein Entlanggleiten der Heizeinrichtung auf dem Halbleitermaterial nicht erforderlich.

Durch die Einstellung der Temperatur des Lotes und der der Sonotrode und der Heizeinrichtung bildet sich aus der Lötstelle heraus ein Temperaturgradient, der aufgrund der erfindungsgemäßen Lehre eine Rissbildung ausschließt. Durch die Einstellung von Leistung sowie Frequenz der Ultraschallvorrichtung wird des Weiteren sichergestellt, dass das Lot im gewünschten Umfang mit dem Werkstückmaterial - im Falle einer Rückseite einer Solarzelle mit einer gesinterten oder gesputterten Aluminiumschicht - im erforderlichen Umfang eine Verbindung oder eine Legierung eingeht und dass eine hinreichende Haftfestigkeit sichergestellt ist mit der Folge, dass die auf sodann aufzulötende Leiterbahnen einwirkenden Abzugskräfte zu einem Lösen nicht führen.

Es hat sich herausgestellt, dass dann, wenn die Prozesswärme durch das Lot, bevorzugterweise ausschließlich durch das Lot auf die Werkstücke wie bruchgefährdete Solarzellen eingebracht wird, ein außerordentlich schonendes Verfahren zur Verfügung steht.

Durch das Applizieren von Ultraschall wird sichergestellt, dass etwaige vorhandene Oxidschichten auf der Werkstückoberfläche, auf die das Lot aufgelötet werden soll, aufgebrochen werden, so dass die gewünschte Verbindung zwischen Lot und Material bzw. ein Einlegieren des Lots in das Material im erforderlichen Umfang ermöglicht wird. Eine mögliche Erklärung ist, dass beim Einbringen von Ultraschallschwingungen in die Lotschmelze Kavitäten erzeugt werden, die zusammenfallen und Schockwellen in das Material der Metallisierung eintragen. Durch diese mikromechanische Belastung wird das darunter liegende Materialgefüge zerstört und z. B. eine Legierungsbildung mit dem Lot angeregt. Oxidschichten, die sich an der Metalloberfläche befinden, werden zerstört, so dass ein flussmittelfreies Löten möglich wird. Soll eine ausreichend feste Legierung erzeugt werden, wird die Löttemperatur ausreichend hoch gewählt, wobei die Nebenbedingung berücksichtigt wird, dass die photovoltaischen Eigenschaften einer Solarzelle nicht beeinträchtigt werden, sofern eine Solarzelle als Werkstück verwendet wird.

Soll das Lot auf einer Aluminiumschicht aufgelötet werden, so können Temperaturen bis 500 °C erforderlich sein. Dabei ist vorgesehen, dass die Temperatur des Lotmaterials zwischen 180 °C und 500 °C, vorzugsweise 250 °C und 400 °C bei einem Lotmaterial eingestellt wird, das aus Zinn besteht oder Zinn enthält. Hierdurch werden die Eigenschaften einer Solarzelle nicht negativ beeinflusst.

In der Sonotrode werden stehende Longitudinalwellen erzeugt, die sich in Längsrichtung der Sonotrode erstrecken. Dabei ist die Sonotrode derart auf die Wellenlänge ausgelegt, dass der Schwingungsbauch im Sonotrodenkopf, d. h. der Spitze, die mit dem Lot kontaktiert ist, verläuft. Hierdurch können sich die gewünschten Kavitäten ausbilden. Sollen insbesondere Oxidschichten zerstört werden, kann es von Vorteil sein, wenn die Längsachse der Sonotrode mit der Normalen nicht zusammenfällt, die von der Oberfläche des Werkstücks, die der Sonotrode zugewandt ist, zusammenfällt. Erfindungsgemäß ist daher vorgesehen, dass die Sonotrodenlängsachse zur Normalen unter einem definierten Winkel eingestellt werden kann. Dieser liegt zwischen 0° und 90°, wobei dann, wenn Sonotrodenlängsachse und Normale nicht zusammenfallen sollen, ein Winkel zwischen 20° und 60° eingestellt werden sollte, bezogen auf die Normale. Hierdurch können im erforderlichen Umfang Oxidschichten aufgebrochen werden, wie dies beim Ultraschallmetallschweißen der Fall ist.

Unabhängig hiervon kann in Weiterbildung der erfindungsgemäßen Lehre zur Erzielung einer Prozessstabilität das Ultraschallsystem ununterbrochen aktiv sein, um eventuell auftretende Resonanzabweichungen beim Ansteuern der Ultraschallsysteme zu vermeiden. Eine ununterbrochene Betätigung der Ultraschallsysteme führt auch zu dem Vorteil, dass lotbedingte Benetzungseigenschaften stabilisiert werden.

Ein weiterer hervorzuhebender eigenerfinderischer Gedanke sieht vor, dass bei Solarzellen als Halbleiterelemente anstelle der üblicherweise z.B. aus Silber bestehenden Stromableiter (Busbars) Lötstreifen an sich die zuvor auf der Solarzelle aufgebrachten Stromsammler (Finger) verbinden.

Da die Busbars in Form der Lötstreifen die Finger elektrisch leitend verbinden müssen, ohne dass ein Durchkontaktieren zur zugewandten Halbleiterschicht der Solarzelle erfolgen darf, wodurch andernfalls Kurzschlüsse entstehen würden, muss sichergestellt sein, dass beim Auflöten der Lötstreifen mittels Ultraschall die insbesondere aus SiNₓ bestehende Außenschicht der Solarzelle, die als Antireflexionsschicht dient, nicht zerstört wird. Hierzu wird erfindungsgemäß der Gedanke genutzt, dass die Längsachse der Sonotrode zur von der Solarzellenoberfläche ausgehenden Normalen einen Winkel einschließt, der größer als 0°, insbesondere im Bereich zwischen 20° und 60° liegt. Hierdurch bedingt wirken beim Ultraschalllöten transversale Schwingungskomponenten der Ultraschallschwingungen ein, so dass gezielt ein Verlöten mit den Fingern (Lotstreifen oder -balken) erfolgen kann, ohne dass die Frontschicht wie SiNₓ-Schicht derart zerstört wird, dass ein Kontaktieren mit der darunter befindlichen Halbleiterschicht erfolgt. Das Auflöten der Lötstreifen erfolgt vorzugsweise bei niedrigen Ultraschall-Frequenzen im Bereich zwischen 20 bis 40 kHz.

Insbesondere ist vorgesehen, dass die Ultraschallwellen bei geneigt oder im Extremfall parallel zu von dem Werkstück aufgespannter Ebene ausgerichteter Sonotrodenlängsachse appliziert werden. Auch kann eine Anregung der Sonotrode mit einer Frequenz erfolgen, die von der Resonanzfrequenz abweicht. Dies kann durch Verstimmen der Sonotrode oder durch Auswahl einer Länge der Sonotrode erfolgen, die von λ/2 oder einem ganzzahligen Vielfachen von λ/2 abweicht.

Erfindungsgemäß kann Lot in Form von Lötstreifen aufgebracht werden, die insbesondere aus Zinn bestehen und mit einer Geschwindigkeit zwischen 2 mm/sec und 200 mm/sec, insbesondere zwischen 22 mm/sec und 80 mm/sec aufgetragen werden. Dabei besteht auch die Möglichkeit, Lötstreifen als Busbars auf der Vorderseite einer Solarzelle mit Ultraschall aufzubringen. Die Lötstreifen, also vorzugsweise Zinnstreifen, sollten eine Breite zwischen 1 und 3 mm, vorzugsweise von in etwa 2 mm aufweisen.

In Weiterbildung der Erfindung ist vorgesehen, dass das Lot Schleifmittel enthält, um insbesondere die Oberfläche der Metallschicht, auf die das Lot aufgelötet werden soll, aufzubrechen bzw. Oxidschichten zu entfernen.

Beispielhaft können Schleifmittelzusätze benutzt werden, wie diese der DE-T-692 22 611 zu entnehmen sind, auf deren Offenbarung ausdrücklich Bezug genommen wird.

Ergänzend oder alternativ können im Lot gelöste und bei Abkühlung des Lots ausfallende Legierungskomponenten eingesetzt werden, die möglichst harte Präzipitate bilden. So kann z. B. ein mit dem Metallelement Me angereichertes aus Zinn bestehendes oder Zinn enthaltendes Lot bei geringer Abkühlung mikrometergroße Feststoffpartikel des Elementes Me oder der Verbindung SnₓMe₁₋ₓ ausscheiden, die z. B. den mechanischen Abrieb einer Oxidschicht verstärken können. Dabei kann Me zumindest ein Metall aus der Gruppe Zn, Ag, Cu, Al, Mg, Ca, Ba, Pb, Sb, Bi, Ni, Ge, Si sein.

Des Weiteren sieht die Erfindung vor, dass vor Aufbringen des Lots eine auf dem Werkstück vorhandene Oxidschicht wie Aluminiumoxidschicht durch z. B. Überziehen mit einem Werkzeug geglättet wird. Durch diese Maßnahmen wird die Oxidschicht plastisch verformt, wodurch aufgrund der vorhandenen Sprödigkeit eine Zerstörung erfolgt.

Durch die Anwendung von Ultraschall und dessen Ausrichtung zur Normalen können durch den während des Auflötens eingekoppelten Ultraschall vorhandene Oxidschichten wie Aluminiumoxidschichten zerstört werden. Gleichzeitig wird das Oberflächenschichtgefüge des Werkstücks durch aufgrund des eingekoppelten Ultraschalls in dem Lot entstehende Kavitäten und dessen Zusammenfallens aufgebrochen, so dass ein Einlegieren des Lots in das Schichtenmaterial ermöglicht wird. Es bildet sich eine Legierung zwischen dem Lot und dem Schichtenmaterial. Das Ausmaß dieser Teilreaktion wird über die Winkelstellung der Längsachse der Sonotrode zur Normalen der Werkstückoberfläche beeinflusst und ist entsprechend dem Metallisierungsschichtenmaterial, auf das das Lot aufgelötet werden soll, zu optimieren.

Eine weitere zu beachtende Prozessgröße ist der Abstand zwischen Sonotrodenkopf, d. h. der Spitze zu der Werkstückoberfläche, über den die Dicke der Lotschicht (Höhe) über dem Werkstück vorgegeben wird. Die Dicke kann auf einfache Weite mechanisch eingestellt werden.

Dies kann durch den Abstand der Sonotrode, d. h. deren Kopf oder Spitze, zu der Werkstückoberfläche erfolgen. Dabei ist insbesondere vorgesehen, dass mittels einer Mikrometerschraube die Sonotrode in einem Abstand zwischen 0 µm und 500 µm, vorzugsweise zwischen 50 µm und 100 µm, zu der Oberfläche eingestellt wird, so dass hierdurch die Schmelztiefe vorgegeben wird.

Die Sonotrode, d. h. deren Spitze sollte des Weiteren zwischen sich ggf. auf dem Werkstück abstützenden Kufen der Heizeinrichtung angeordnet sein, und zwar in Längsrichtung der Kufen betrachtet im Bereich deren vorderen Enden oder vor diesen. Dabei sollten die Kufen die Temperatur der Lotheizung aufweisen, also die Temperatur des Lots beim Austritt aus der Heizeinrichtung, so dass infolgedessen definierte Temperaturbedingungen herrschen.

Die zum Einsatz gelangende Ultraschalleinrichtung, die eine Sonotrode oder ein gleichwirkendes Element umfasst, sollte mit einer Frequenz zwischen 20 kHz und 100 kHz, vorzugsweise im Bereich zwischen 40 kHz und 80 kHz erregt werden.

Damit die Werkstücke, auf die das Lot aufgelötet wird, bruchfrei prozessiert werden können, werden die Werkstücke quasi federnd gelagert. Hierzu ist beispielsweise vorgesehen, dass die Werkstücke über Zahnriemen, Rundschnurringe oder Flachriemen in einer Lötzone eingeführt werden, in der die Heizeinrichtung mit der Sonotrode angeordnet ist. Da beim Absenken der Ultraschallsonotrode auf das Werkstück auf dieses über das Lot eine Kraft eingeleitet wird, die zu einem Verbiegen führen könnte, erfolgt eine weiche oder federnde Abstützung, die erwähntermaßen insbesondere durch Abstützen auf Transportriemen erfolgt, die ein Auslenken des Werkstücks durch das Aufsetzen der Ultraschallsonotrode kompensieren. Somit kann ein Verbiegen des Werkstücks, das von Werkstück zu Werkstück unterschiedlich ausfallen kann, nicht zu Schädigungen führen. Ferner ergibt sich hierdurch der Vorteil, dass eine mikrometergenaue Positionierung der Sonotrode relativ zur Oberfläche des Werkstücks nicht zwingend erforderlich ist, da die Transportbänder bzw. Riemen das Werkstück mit im Wesentlichen konstanter geringer Kraft in Richtung der Sonotrode drücken.

Daher zeichnet sich eine Vorrichtung der eingangs genannten Art auch dadurch aus, dass die Transporteinrichtung das Werkstück federnd durch die Lötzone transportiert.

Es wird vorgeschlagen, dass die Transporteinrichtung das Werkstück durch Andrücken dieses in Richtung der Ultraschallsonotrode federnd durch die Lötzone transportiert.

Insbesondere ist vorgesehen, dass die Transporteinrichtung erste und zweite Transportelemente umfasst, zwischen denen das Werkstück klemmend fixiert ist, wobei das erste Transportelement aktiv angetrieben wird und das zweite Transportelement durch Reibschluss mit dem ersten Transportelement bzw. dem Werkstück angetrieben wird.

Insbesondere sind das erste und das zweite Transportelement Endlosflach- oder -rundelemente wie Flachriemen oder Rundschnüre, wobei das erste und/oder das zweite Transportelement zwei zueinander beabstandete Endlosflach- oder -rundelemente aufweist, die über jeweils von einer gemeinsamen Achse ausgehenden Umlenkrollen geführt sind. Dabei sollte die erste Transporteinrichtung über eine dritte Transporteinrichtung angetrieben werden, über die das Werkstück der ersten und zweiten Transporteinrichtung zuführbar ist, in deren Bereich die Lötzone verläuft.

Die Heizeinrichtung und die Ultraschallsonotrode sollten von einer gemeinsamen Halterung ausgehen, zu der die Heizeinrichtung und die Ultraschallsonotrode als Einheit zu der Transportebene des Werkstücks verstellbar sind, die durch die erste Transporteinrichtung vorgegeben ist. Zusätzlich ist eine Relativverstellung zwischen Ultraschallsonotrode und Heizeinrichtung möglich, um die Dicke (Höhe) des aufzutragenden Lots einstellen zu können. Die Breite ist zusätzlich von der Menge des Lotauftrags abhängig.

Die Heizeinrichtung weist eine geschmolzenes Lot abgebende und auf die Transportebene ausgerichtete Austrittsöffnung auf. Ferner kann unmittelbar im Bereich der Austrittsöffnung oder beabstandet zu dieser die Sonotrode mit ihrer das geschmolzene Lot kontaktierenden Sonotrodenspitze angeordnet sein.

Des Weiteren ist vorgesehen, dass die Vorrichtung zumindest einen gegenüber der Heizeinrichtung isolierten Gasführungskanal aufweist, von dem Schutzgas der Lötzone zuführbar ist. Hierbei kann es sich um Argon, Stickstoff oder Formiergas handeln.

In Weiterbildung der Erfindung ist vorgesehen, dass der Heizeinrichtung bzw. Ultraschallsonotrode bzw. der gemeinsamen Halterung eine Reinigungseinrichtung zugeordnet ist, um lotbedingte Verkrustungen an der Heizeinrichtung bzw. der Sonotrode zu entfernen. Auch kann eine Absaugvorrichtung vorgesehen sein, um lotbedingte Verschmutzungen zu entfernen.

Da alle wesentlichen prozessrelevanten Komponenten von der gemeinsamen Halterung ausgehen, kann eine einfache Wartung erfolgen.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines bevorzugten Ausführungsbeispiels.

Es zeigen:
- Fig. 1: eine Seitenansicht einer Transporteinrichtung,
- Fig. 2: einen Schnitt entlang der A-A in Fig. 1,
- Fig. 3: eine Prinzipdarstellung einer Einrichtung zum Abgeben geschmolzenen Lots mit Ultraschalleinrichtung,

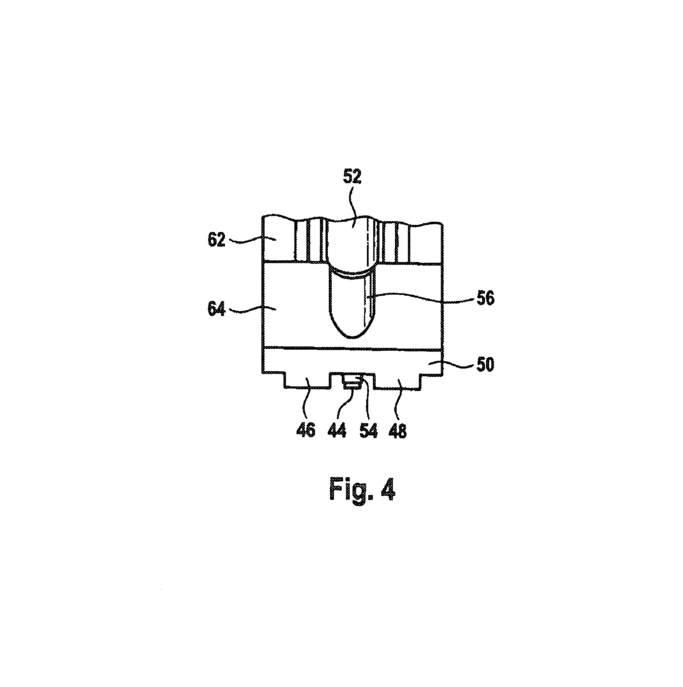

- Fig. 4: einen Ausschnitt der Anordnung gemäß Fig. 3,
- Fig. 5: eine Positionierung einer Sonotrode einer Ultraschalleinrichtung zu einem Halbleiterbauelement,
- Fig. 6: eine alternative Positionierung der Sonotrode zu dem Halbleiterbauelement nach Fig. 5,
- Fig. 7: eine Anordnung im Ausschnitt zum Erwärmen eines Halbleiterbauelementes,
- Fig. 8: eine Anordnung zum Glätten einer Lotbahn und
- Fig. 9: eine Prinzipdarstellung einer Solarzelle in Draufsicht.

Den Figuren, in denen grundsätzlich gleiche Elemente mit gleichen Bezugszeichen versehen sind, sind rein prinzipiell Anordnungen und Maßnahmen zum Aufbringen von Lot auf ein flächiges Werkstück und Auflöten des Lots auf das Werkstück zu entnehmen. Dabei wird die erfindungsgemäße Lehre nachstehend anhand einer Solarzelle als Werkstück erläutert, ohne dass hierdurch eine Einschränkung erfolgen soll. Auch sind die beschriebenen Transporteinrichtungen beispielhaft zu verstehen und können durch gleichwirkende Elemente ersetzt werden, die die erläuterte Wirkung sicherstellen, so dass die entsprechenden technischen Begriffe als Synonyme zu verstehen sind.

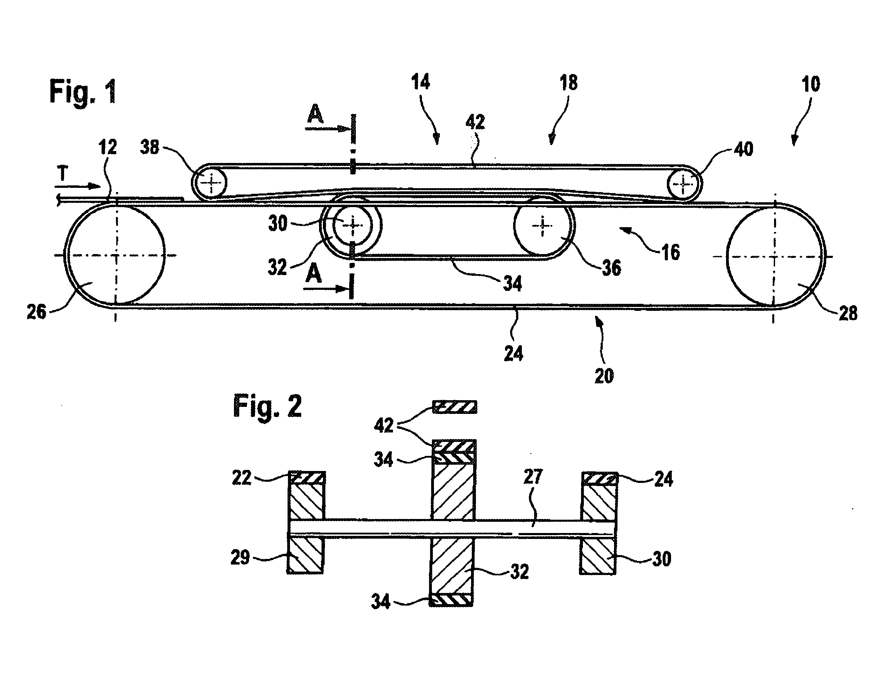

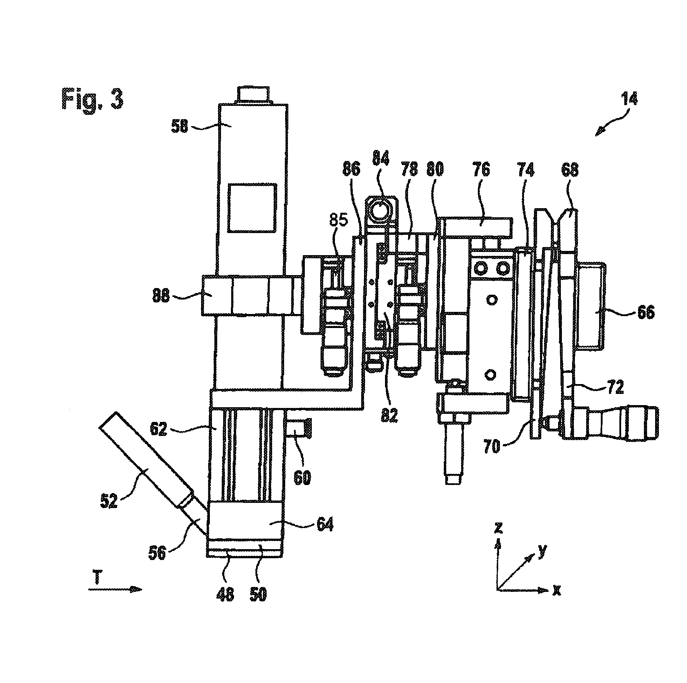

Der Fig. 1 ist ein Transportsystem 10 zu entnehmen, mittels dem Solarzellen 12 durch eine Lötstation gefördert wird, die prinzipiell der Fig. 3 zu entnehmen ist und das Bezugszeichen 14 aufweist.

Eine Transporteinrichtung 20 umfasst zwei zueinander beabstandete Zahnriemen 22, 24, die über gemeinsame Zahnriemenscheiben 26, 28 angetrieben werden. Die Zahnriemen 22, 24 treiben über eine Welle 27 miteinander verbundene Zahnriemenscheiben 29, 30 an. Von der Welle 27 geht eine Flachriemenscheibe 32 aus, um die ein hochelastischer Flachriemen 34 geführt und angetrieben wird. Der Flachriemen 34 wird des Weiteren um eine weitere Flachriemenscheibe 36 geführt. In der zeichnerischen Darstellung der Fig. 1 verläuft oberhalb des Flachriemens 34 ein um Umlenkrollen oder -scheiben 38, 40 geführter Flachriemen 42, zwischen dem und dem hochelastischen Flachriemen 34 die Solarzelle 12 durch die Lötstation 14 gefördert wird. Der Transport des Flachriemens 42 erfolgt demzufolge durch Reibschluss mit dem Flachriemen 34 bzw. der zu prozessierenden Solarzelle 12, sofern diese über die Zahnriemen 22, 24 in den Bereich zwischen dem Flachriemen 34, 42 eingebracht worden ist. Die Ausrichtung der Flachriemen 34, 42 und damit deren Lagerungen erfolgt dabei derart, dass der erforderliche Freiraum zwischen den Flachriemen 34, 42 zum Fördern der Solarzelle 12 zur Verfügung steht.

Aus einem Vergleich der Fig. 1 und 2 wird verdeutlicht, dass die Solarzelle 12 in etwa mittig von den Flachriemen 34, 42 erfasst und mittels dieser transportiert wird.

Selbstverständlich besteht auch die Möglichkeit, dass zueinander beabstandete zwei untere und zwei diesen zugeordnete obere Flachriemen zum Transport der Solarzelle 12 verwendet werden, so dass diese in zwei zueinander beabstandeten streifenförmigen Bereichen mit den Flachriemen kontaktiert werden.

Die Transportrichtung ist mit T gekennzeichnet.

Um auf die Solarzelle 12 Lot aufzubringen und aufzulöten, wird dann, wenn sich die Solarzelle 12 im Bereich der Lötstation 14 befindet - dies kann über einen nicht dargestellten Sensor erfasst werden -, die Lötstation 14 in Richtung der Solarzelle 12 verstellt. Hierzu erforderliche Steuersignale können von dem zumindest einen Sensor generiert werden. Das Verstellen der Lötstation 14 in Richtung der Solarzelle 12 erfolgt in nachstehend beschriebener Weise, damit ein Kontakt zwischen einem Sonotrodenkopf 44 eines Ultraschallschwingers 58 und dem aus der Lötstation 14 austretenden und auf der Solarzelle 12 aufgetragenen Lot erfolgt. Dabei liefert der angetriebene hochelastische Flachriemen 34 die notwendige Gegenkraft zur bruchfreien Kontaktierung des Sonotrodenkopfs 44 und der Solarzelle 12 und - sofern vorhanden - zu auf der Solarzelle 12 aufgesetzten Kufen 46, 48 einer Heizeinrichtung 50. Der Heizeinrichtung 50 wird über eine Zuführung 52 Lot zugeführt, das in der Heizeinrichtung 50 schmilzt und über eine Austrittsöffnung 54 auf die Solarzelle 12 unmittelbar vor den Sonotrodenkopf 44 aufgegeben wird. Die Zuführeinrichtung 52 ist dabei gegenüber der Heizeinrichtung 50 über eine Zuführungsisolierung 56 isoliert.

Der Elastizitätsmodul in E in kN/mm² des Flachriemens 34 sollte im Bereich zwischen 0,01 kN/mm² und 0,1 kN/mm² liegen, um die Solarzelle 12 hinreichend elastisch zu lagern, damit beim Auftragen des Lots und dem Zusammenwirken mit der Sonotrode 44 bzw. den von dieser applizierten Ultraschallschwingungen eine Zerstörung der Solarzelle 12 ausgeschlossen wird.

Wenn z.B. das Transportelement ein Antriebsriemen ist, drückt dieser Riemen das Werkstück mit einer Kraft K, die nach dem Hooke'schen Gesetz proportional zur Auslenkung Δx ist, gegen die Sonotrode: K = k * Δx.

Die Proportionalitätskonstante liegt zwischen 1 n/mm und 100 N/mm, wobei vorzugsweise 5N/mm ≤ k ≤ 50 N/mm ist. Dieser Wert ist gültig, wenn das Werkstück eine bruchempfindliche Solarzelle der Dicke 160 ― 200 µm ist. Bei einer Auslenkung um 0,2 mm beträgt die Kraft 2N.

In diesem Fall betrug der Elastizitätsmodul des Riemens 0,01 bis 0,1 kN/mm². Dies ist nur ein Beispiel. Man kann auch alternativ über ein Experiment prüfen, ob die Solarzelle oder ein beliebiges Werkstück unter dem Druck der Sonotrode Risse erhält oder bricht.

Der Sonotrodenkopf 44 ist die Spitze des Ultraschallschwingers 58, bei dem es sich um einen solchen handelt, wie dieser vom Metallultraschallschweißen bekannt ist. Gegebenenfalls kann der Schwinger 58 einen Booster umfassen. Der Ultraschallschwinger erzeugt im gewünschten Frequenzbereich, vorzugsweise im Bereich zwischen 20 kHz und 80 kHz, Ultraschallschwingungen. Hierbei handelt es sich um Longitudinalwellen, wobei der Schwinger 58 derart auf die Wellenlänge der Ultraschallschwingungen abgestimmt ist, dass ein Schwingungsbauch im Bereich des Sonotrodenkopfes 44 verläuft, und zwar in dem Bereich, in dem der Sonotrodenkopf 44 das auf die Solarzelle 12 aufgetragene Lot kontaktiert.

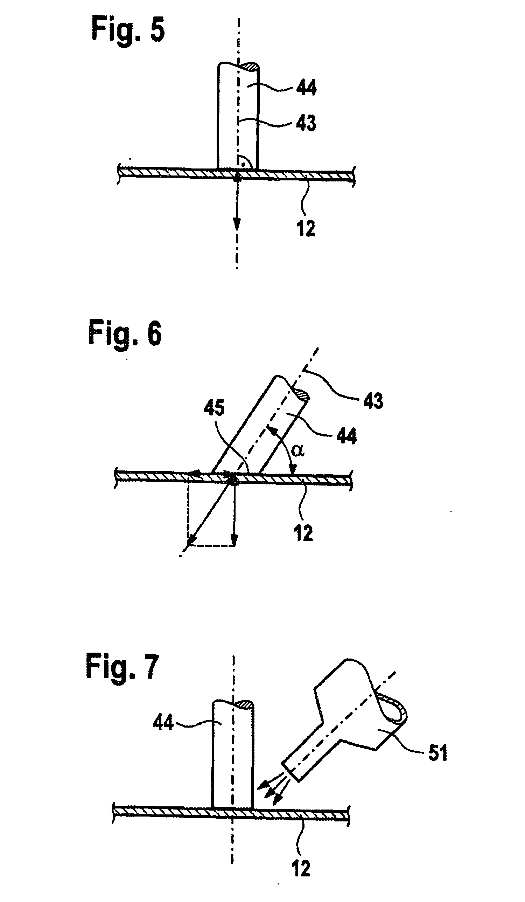

Der Sonotrodenkopf 44 berührt mit seiner Spitze das Lot, das auf die Oberfläche der Solarzelle 12 aufgetragen ist. Dies ergibt sich auch prinzipiell aus den Fig. 5 ― 7. Da das Lot nicht über den Sonotrodenkopf 44 bzw. dessen Spitze erwärmt werden muss, kann der Durchmesser des Sonotrodenkopfs bzw. der Spitze verringert werden. Dadurch kann die Kontaktfläche zwischen dem Sonotrodenkopf 44 und dem Lot im Vergleich zu bekannten Anordnungen in gewünschtem Umfang minimiert werden, um sowohl schmale als auch breite Leiterbahnen ― wie gewünscht - herzustellen. So kann die Erstreckung der Spitze des Sonotrodenkopfs 44 quer zur Auftragsrichtung des Lots, also quer zur Transportrichtung T ohne Weiteres im Bereich zwischen 0,5 mm und 5 mm liegen.

Aus den Fig. ergibt sich des Weiteren rein prinzipiell, dass der Lötstelle über ein Ventil 60 Schutzgas über Kanäle 62 zugeführt werden kann, also dem Bereich, in dem das Lot aus der Düse 54 austritt und mit dem Sonotrodenkopf 44 kontaktiert wird. Hierzu ist der Düsenkanal 62 gegenüber der Heizeinrichtung 50 entsprechend isoliert (Bezugszeichen 64).

Um die Einheit Heizeinrichtung 50 - Schwinger 58 zu der Oberfläche der Solarzelle 12 ausrichten zu können, geht die Lötstation 14 von einer Montageplatte 66 aus, die mit einer stationären Halterung wie Gestell verbunden ist.

Damit die Heizung 50 und folglich die Kufen 46, 48 und der Schwinger 58 und damit der Sonotrodenkopf 44 in x-Richtung verstellt werden können, ist mit der Montageplatte 66 eine Winkelplatte 68 verbunden, die aus zwei gegeneinander verstellbaren Plattenelementen 70, 72 besteht. In Bezug auf den Verbindungspunkt der Plattenelemente 70, 72 kann ein Winkel von ± 5° zur Vertikalen (Z-Richtung) eingestellt werden.

Die Winkelplatte 68 ist über eine Adapterplatte 74 mit einer Hubeinheit 76 verbunden, mittels der die Einheit Schwinger 58 - Heizung 50 in z-Richtung verstellbar ist. Die Hubeinheit 76 ermöglicht infolgedessen das Absenken zu bzw. Abheben von der zu prozessierenden Solarzelle 12.

Eine Feinverstellungseinheit 78 ist über eine Adapterplatte 80 mit der Hubeinheit 76 verbunden. Die Feinverstellungseinheit 78 erlaubt ein weiteres Verstellen in z-Richtung, um somit eine exakte Justierung des Sonotrodenkopfes 44 zu der Solarzelle 12 zu ermöglichen, also zu deren Oberfläche, wodurch die Dicke bzw. Höhe des aufzulötenden Lots vorgegeben wird.

Die Feinverstellungseinheit 78 wird über eine weitere Adapterplatte 82 mit einer Verstelleinrichtung 84 verbunden, die mit einem Winkelelement 86 verbunden ist, von der die Heizung 50 und der Schwinger 58 ausgehen.

Die Verstelleinrichtung 84 ermöglicht ein Verstellen des Winkelelements 86 in y-Richtung.

Starr mit dem Winkelelement 86 ist die Heizeinrichtung 50 mit der Lotzuführeinrichtung 52 und dem Gasanschluss 60 sowie den Gaskanälen 62 verbunden. Relativ zu diesen ist der Schwinger 58 über eine Verstelleinheit 85 in z-Richtung verstellbar. Hierzu geht von der Verstelleinrichtung 85 ein Befestigungselement 88 wie Schelle aus, von der der Schwinger 58 aufgenommen ist. Das Befestigungselement 88 verläuft dabei im Schwingungsknoten des Schwingers 58.

Durch einen diesbezüglichen Aufbau der Lötstation 14 besteht die Möglichkeit, im gewünschten Umfang den Schwinger 58 und damit den Sonotrodenkopf 44 zur Oberfläche der Solarzelle 12 auszurichten, um gleichzeitig jedoch gewünschtenfalls die Möglichkeit zu bieten, dass die Kufen 46, 48 der Heizeinrichtung 50 auf der Solarzellenoberfläche abgestützt sind. Hierbei handelt es sich jedoch nicht um ein zwingendes Merkmal. Vielmehr können die Teil der Heizeinrichtung 50 bildenden Kufen 46, 48 auch beabstandet zur Solarzelle12 verlaufen.

Ist im Ausführungsbeispiel die Lötstation 14 derart ausgelegt, dass der Schwinger 58 in Bezug auf das Winkelelement 86 ausschließlich in z-Richtung verstellbar ist, so kann gleichfalls konstruktiv die Möglichkeit gegeben sein, dass auch ein Ausrichten der Längsachse des Schwingers 58 in einem gewünschten Winkel zur z-Achse erfolgt, die entlang der von der Oberfläche der Solarzelle 12 ausgehenden Normalen verläuft. Somit besteht die Möglichkeit, gewünschte Winkel des Sonotrodenkopfs 44 zur Oberfläche einzustellen, um im erforderlichen Umfang z. B. Oxidschichten aufbrechen zu können, sofern dies bei einer Ausrichtung des Schwingers 58 entlang der Normalen nicht im erforderlichen Umfang möglich sein sollte.

Um dies zu verdeutlichen, sind Prinzipdarstellungen von Ausrichtungen des Sonotrodenkopfs 44 zu der Oberfläche der Solarzelle 12 in den Fig. 5 und 6 dargestellt.

Wie zuvor erläutert worden ist, kann die Ultraschalleinwirkung der von der Sonotrode 42 übertragenen Ultraschallwellen in die Solarzelle 12 hinein über die eingesetzte Sonotrodenform und Ausrichtung zu der Solarzelle 12 beeinflusst werden. In Fig. 5 ist dabei die Sonotrode mit ihrer Längsrichtung 43 parallel zur Normalen ausgerichtet, die von der Oberfläche der Solarzelle 12 ausgeht. Somit weisen die von der Sonotrode 44 erzeugten Ultraschallschwingungen im Wesentlichen longitudinale Schwingungskomponenten auf, die auf die Solarzelle 12 bzw. das Lot einwirken. Die Sonotrodenlängsachse 43 verläuft im rechten Winkel zur Oberfläche der Solarzelle 12. Wird die mit dem Lot zu kontaktierende Kontaktfläche 45 der Sonotrode 44 zur Längsachse 43 unter einem Winkel α mit α ≠ 90° ausgerichtet, so wird die erzeugte Ultraschallschwingung in eine longitudinale und eine transversale Schwingungskomponente aufgeteilt (siehe Fig. 6). Mit dieser Variante wird verhindert, dass z.B. eine nicht zu zerstörende Oberflächenschicht wie SiNₓ-Schicht der Solarzelle 12 beim Auflöten des Lots nicht derart mechanisch belastet wird, dass das Lot unmittelbar die Halbleiterschicht kontaktiert mit der Folge, dass Kurzschlüsse vermieden werden. Mit anderen Worten ist sicherzustellen, dass die Oberflächenschicht dicht bleibt.

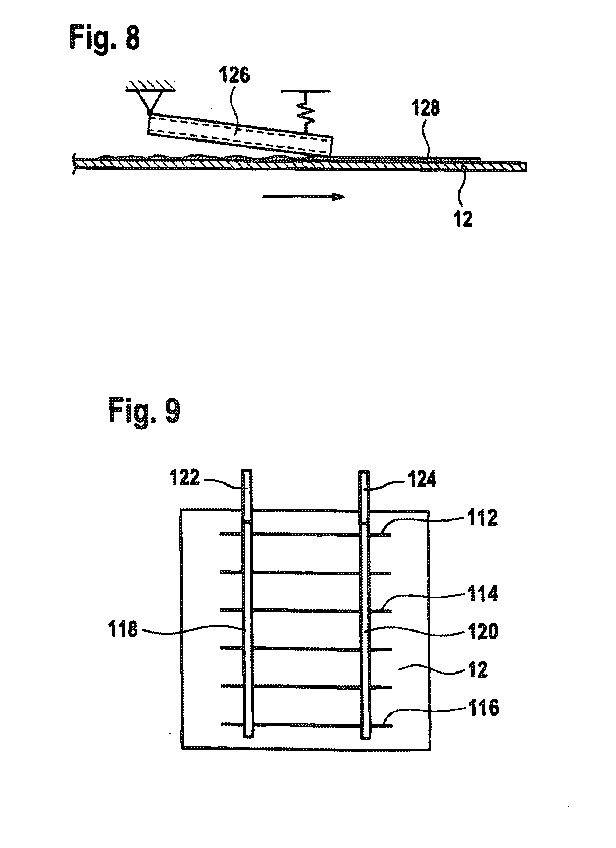

Diesbezügliche Maßnahmen sind insbesondere dann von Vorteil, wenn z.B. die auf der Vorderseite der Solarzelle 12 vorhandenen Finger bildenden Stromsammler 112, 114, 116 über aus Lot bestehende Balken oder Streifen 118, 120 elektrisch leitend verbunden werden, die somit die nach dem Stand der Technik insbesondere aus Silber bestehenden Stromableiter oder Busbars ersetzen. Hierdurch erfolgt eine kostengünstige elektrisch leitende Verbindung der Finger 112, 114, 116. Von den die Busbars bildenden Lötstreifen 118, 120 können dann die zum Verschalten von Solarzellen 12 benötigten Verbinder wie verzinnte Kupferverbinder ausgehen, die mit den Lötbahnen 118, 120 mittels Ultraschall verlötet werden. Die entsprechenden Verbinder sind in Fig. 9 mit den Bezugszeichen 122, 124 gekennzeichnet.

Die erforderliche Wärme der Solarzelle 12, um das Lot auflöten zu können, wird bevorzugterweise erfindungsgemäß von dem Lot selbst übertragen, wobei ggfs. eine Vorerwärmung der Solarzelle 12 über die Heizeinrichtung 50 bzw. die Kufen 46, 48 erfolgen kann.

Es besteht auch die Möglichkeit, dass der Sonotrodenkopf 44 auf die Temperatur der Heizanordnung 50 erwärmt wird. Dies ist jedoch kein zwingendes Merkmal.

Dadurch, dass die erforderliche Wärme zum Schmelzen des Lots in Abweichung von vorbekannten Techniken nicht über den Sonotrodenkopf 44 übertragen wird, kann dieser im Bereich des Kontakts mit dem Lot relativ schmal bzw. mit geringem Querschnitt bzw. Durchmesser ausgebildet werden. Insbesondere ist vorgesehen, dass die Erstreckung des Sonotrodenkopfs quer zur Auftragsrichtung, die der Transportrichtung T entspricht, zwischen 0,5 mm und 5 mm liegt, wobei der Querschnitt ein Kreis, eine Ellipse oder ein Rechteck bzw. Quadrat sein kann. Im Fall eines Rechteckes kann die Seitenlänge folglich 0,5 mm ― 5 mm quer zur Auftragsrichtung und im Falle eines Kreises bzw. einer Ellipse Durchmesser bzw. Erstreckung der Ellipse quer zur Transportrichtung 0,5 mm ― 5 mm betragen, wobei auch abweichende Größen, insbesondere Erstreckungen bis in den cm-Bereich gewählt werden können, sofern dies erforderlich sein sollte.

Eine weitere von der erfindungsgemäßen Lehre erfasste Variante ist der Fig. 7 zu entnehmen, um die Solarzelle 12 im gewünschten Umfang zu erwärmen. So kann anstelle der Heizeinrichtung 50, die zur Vorheizung der Solarzelle 12 und zum Aufschmelzen bzw. Erhitzen des Lotmaterials dient, eine Heizeinrichtung 51 Verwendung finden, die eine Heißluftdüse umfasst. Die von der Heißluftdüse 51 abgegebene warme Luft dient dabei zum Vorheizen der Solarzelle 12 bzw. zum Aufschmelzen oder weiteren Erhitzen des Lotmaterials. Die erhitzte Luft tritt unter einem gewünschten Winkel auf den Kontaktbereich zwischen Solarzelle 12 und dem Lotmaterial auf, wird bevorzugterweise auf den Kontaktbereich zwischen der Sonotrode 44 und der Solarzelle 12 ausgerichtet, wie prinzipiell der Fig. 7 zu entnehmen ist. Somit kann das Lotmaterial direkt an der gegebenenfalls ebenfalls beheizten Sonotrode 44 aufgeschmolzen werden, um sodann mittels Ultraschall das Lotmaterial aufzulöten.

Für das weitere Prozessieren kann es wünschenswert sein, dass das aufgebrachte Lotmaterial geglättet wird bzw. vorhandene Oxidation verringert und/oder eventuelle Verunreinigungen an der Oberfläche entfernt werden, da durch Ultraschalleinwirkung die elektrisch leitende Kontaktfläche auf der Solarzelle auf Grund von Unebenheiten und Verunreinigungen zu erhöhter Oxidation neigt. Um die Oxidation zu verringern und eventuelle Verunreinigungen an der Oberfläche zu entfernen, ist erfindungsgemäß vorgesehen, dass ein erneutes Aufschmelzen und Glätten der Kontaktfläche erfolgt. Hierzu ist gemäß Fig. 8 prinzipiell vorgesehen, dass die Lotkontaktfläche nach dem Erstarren mit Hilfe eines Heizelementes wie Heizschiene 126 aufgeschmolzen und durch Relativbewegung zwischen der Solarzelle 12 und der Heizschiene 126 aufgeschmolzen und geglättet wird. Die entsprechende Lotbahn bzw. Lotstreifen ist in Fig. 8 mit dem Bezugszeichen 128 gekennzeichnet.

Diese Maßnahmen können in der Lotstation 14 selbst durchgeführt werden, allerdings nur dann, wenn nicht unmittelbar mit dem Lotauftrag auf die Lotbahn ein elektrischer Leiter aufgelötet wird.

Das erfindungsgemäße Verfahren ist insbesondere für Durchlaufverfahren geeignet. Dabei können in mehreren Bahnen parallel gleichzeitig Halbleiterbauelemente wie Solarzellen mit Lötbahnen versehen werden. Um sowohl auf der Rückseite als auch auf der Vorderseite entsprechende Lötbahnen mittels Ultraschall aufzulöten, können die Solarzellen von einer ersten Lötstation in eine zweite Lötstation übergeben werden. Dies kann z.B. mit Hilfe eines Wenderads oder einer sonstigen geeigneten Einrichtung erfolgen.

## Patentansprüche

1. Verfahren zum Aufbringen von Lot auf ein Werkstück, vorzugsweise auf ein Halbleiterbauelement wie eine Solarzelle, wobei das Lot bei einer Löttemperatur T_{L} und mittels einer Sonotrode unter Ultraschalleinwirkung aufgelötet wird, wobei ferner
das Lot mittels einer Heizeinrichtung erwärmt wird, auf das Werkstück aufgebracht und unter Ultraschalleinwirkung aufgelötet wird, **dadurch gekennzeichnet, dass** das Werkstück während des Auflötens federnd durch Andrücken des Werkstücks in Richtung der Sonotrode mittels einer das Werkstück fördernden Transporteinrichtung gelagert wird.

2. Verfahren nach Anspruch 1,
**dadurch gekennzeichnet,**
**dass** das Lot mittels der Heizeinrichtung auf eine Temperatur T_{L} mit T_{L} ≥ T_{M} erwärmt wird, wobei T_{M} ≠ gleich der Schmelztemperatur des Lots ist.

3. Verfahren nach zumindest Anspruch 1,
**dadurch gekennzeichnet,**
**dass** zum Auflöten erforderliche Wärme über das Lot auf das Werkstück übertragen wird, wobei insbesondere das Lot über die Heizeinrichtung erwärmt wird, die vorzugsweise bei Relativbewegung zwischen dem Werkstück und der Heizeinrichtung mit dem Werkstück zumindest zeitweise kontaktiert wird, insbesondere gleitend auf dem Werkstück entlang geführt wird.

4. Verfahren nach zumindest Anspruch 1,
**dadurch gekennzeichnet,**
**dass** die Höhe des Lots über dem Werkstück durch den Abstand zwischen dem Sonotrodenkopf bzw. dessen Spitze und dem Werkstück und/oder durch die Auftragsmenge des Lots eingestellt wird, und dass vorzugsweise die Längsachse der den Ultraschall applizierenden Sonotrode zur von dem Werkstück ausgehenden Normalen unter einem Winkel α ausgerichtet wird, wobei 0° ≤ α ≤ 90°, vorzugsweise 20° ≤ α ≤ 60° beträgt.

5. Verfahren nach zumindest Anspruch 1,
**dadurch gekennzeichnet,**
**dass** zum Applizieren der Ultraschallschwingungen eine Sonotrode mit einem Sonotrodenkopf mit einem mit dem Lot kontaktierenden Bereich verwendet wird, der aus einem Hartstoffmaterial besteht oder dieses aufweist, insbesondere einer Hartstoffschicht aus z.B. Wolframcarbid, SiC, Diamant, und/oder dass ein Lot verwendet wird, das ein Schleifmittel wie Al₂O₃, SiC, Si₃N₄, SiO₂ enthält, oder dass ein Lot verwendet wird, das eine bei Temperaturabsenkung sich ausscheidende als Schleifmittel wirkende Komponente enthält.

6. Verfahren nach zumindest Anspruch 1,
**dadurch gekennzeichnet,**
**dass** nach Erstarren des Lots dieses erneut erhitzt und durch Druckbeaufschlagung geglättet wird.

7. Verfahren nach zumindest Anspruch 1,
**dadurch gekennzeichnet,**
**dass** während des Auflötens des Lots auf das Werkstück auf das Lot ein elektrischer Leiter wie Verbindungsleiter aufgelötet wird, oder dass nach Auflöten des Lots in einem gesonderten Verfahrensschritt unter Zuführung von thermischer Energie auf das auf das Werkstück aufgelötete Lot ein elektrischer Leiter aufgelötet wird, oder dass auf einer Solarzelle als das Werkstück das Lot in Bahnen oder Streifen zur Bildung von Busbars zum elektrisch leitenden Verbinden mit auf der Solarzelle vorhandenen Stromsammlern aufgelötet wird.

8. Vorrichtung zum Aufbringen und Auflöten eines Lots in einer Lötzone auf ein Werkstück (12), insbesondere auf ein Halbleiterbauelement wie eine Solarzelle, umfassend eine Lotzuführungseinrichtung (54), eine Heizeinrichtung (50) für das Lot, eine Ultraschallsonotrode (58) sowie eine Transporteinrichtung (10) zum Transport des Werkstücks relativ sowohl zu der Heizeinrichtung als auch der Ultraschallsonotrode,
**dadurch gekennzeichnet,**
**dass** die Transporteinrichtung (10) das Werkstück (12) durch Andrücken dieses in Richtung der Ultraschallsonotrode (58) federnd durch die Lötzone transportiert.

9. Vorrichtung nach Anspruch 8,
**dadurch gekennzeichnet,**
**dass** die Transporteinrichtung (10) ein erstes und ein zweites Transportelement (16, 18) aufweist, zwischen denen das Werkstück (12) klemmend fixiert ist, wobei das erste Transportelement (16) aktiv und das zweite Transportelement (18) durch Reibschluss mit dem ersten Transportelement bzw. dem Werkstück oder durch einen zusätzlichen eigenen Antrieb angetrieben ist, wobei vorzugsweise das erste und das zweite Transportelement (16, 18) Endlosflach- oder -rundelemente wie Flachriemen oder Rundschnüre sind und/oder das erste und/oder das zweite Transportelement (16, 18) zwei zueinander beabstandete Endlosflach- oder -rundelemente aufweist, die über von einer gemeinsamen Achse (26) ausgehende Umlenkrollen (29, 30) geführt sind, wobei gegebenenfalls die erste Transporteinrichtung (16) über eine dritte Transporteinrichtung (20) antreibbar ist, über die das Werkstück (12) der ersten und zweiten Transporteinrichtung (16, 18) zuführbar ist.

10. Vorrichtung nach zumindest Anspruch 8,
**dadurch gekennzeichnet,**
**dass** die Heizeinrichtung (50) und die Ultraschallsonotrode (58) als Einheit zu der Transportebene des Werkstücks (12) vorgebenden ersten Transporteinrichtung (16) verstellbar sind, wobei gegebenenfalls die Heizeinrichtung (50) und die Ultraschallsonotrode (58) zueinander und zu der Transportebene verstellbar sind.

11. Vorrichtung nach zumindest Anspruch 8,
**dadurch gekennzeichnet,**
**dass** die Heizeinrichtung (50) eine geschmolzenes Lot abgebende und auf die Transportebene ausgerichtete Austrittsöffnung (54) aufweist, wobei vorzugsweise unmittelbar im Bereich der Austrittsöffnung (54) oder beabstandet zu dieser die Ultraschallsonotrode (58) mit ihrem das geschmolzene Lot kontaktierenden Sonotrodenkopf (44) angeordnet ist.

12. Vorrichtung nach zumindest Anspruch 8,
**dadurch gekennzeichnet,**
**dass** die Vorrichtung zumindest einen gegenüber der Heizeinrichtung (50) isolierten Gaszuführungskanal (62) aufweist, von dem der Lötzone Schutzgas zuführbar ist.

13. Vorrichtung nach zumindest Anspruch 8,
**dadurch gekennzeichnet,**
**dass** die Heizeinrichtung (50) werkstückseitig zumindest eine Gleitkufe (46, 48) aufweist und vorzugsweise über die zumindest eine Gleitkufe (46, 48) gleitend auf dem Werkstück (12) abstützbar ist.

14. Vorrichtung nach zumindest Anspruch 8,
**dadurch gekennzeichnet,**
**dass** mittels eines Sensors das Werkstück (12) bzw. das auf diesem aufgebrachte Lot erfassbar und in Abhängigkeit von den ermittelten Werten die Ultraschallsonotrode (58) zu dem Lot ausrichtbar ist.

15. Vorrichtung nach zumindest Anspruch 8,
**dadurch gekennzeichnet,**
**dass** der mit dem Lot kontaktierende, vorzugsweise eine Hartstoffschicht aus Wolframcarbid, Siliciumcarbid, Bornitrid oder Diamant aufweisende Bereich der Ultraschallsonotrode (58) eine Breite aufweist, die gleich oder kleiner als die Breite eines auf das Werkstück (12) aufgebrachten geschmolzenen Lotstreifens ist.

## Claims

1. Method for the application of solder onto a workpiece, preferably onto a semiconductor component, such as a solar cell, wherein the solder is soldered on at a soldering temperature T_{L} and by means of a sonotrode under the action of ultrasound, wherein further the solder is heated by means of a heating device, is applied onto the workpiece and is soldered on under the action of ultrasound,
**characterized in that**,
the workpiece is supported during the soldering-on in a spring-mounted manner by means of pressing-on the workpiece in the direction of the sonotrode by means of a transport installation that is conveying the workpiece.

2. Method according to claim 1,
**characterized in that**,
the solder is heated by means of a heating device to a temperature T_{L} with T_{L} ≥ T_{M}, wherein T_{M} equals the melting temperature of the solder.

3. Method according to at least claim 1,
**characterized in that**,
the heat required for the soldering-on is transferred via the solder onto the workpiece, wherein particularly the solder is heated via the heating device which is brought into contact with the workpiece at least temporarily, preferably during a relative movement between the workpiece and the heating device, and which is guided along the work piece particularly in a sliding manner.

4. Method according to at least claim 1,
**characterized in that**,
the height of the solder above the workpiece is adjusted by means of the spacing between the sonotrode head and its tip respectively, and the workpiece and/or by means of the application amount of the solder, and that preferably the longitudinal axis of the sonotrode applying the ultrasound is aligned at an angle α to the normal to the workpiece, wherein 0° ≤ α ≤ 90°, preferably 20° ≤ α ≤ 60°.

5. Method according to at least claim 1,
**characterized in that**,
for the application of the ultrasound oscillations a sonotrode is utilized with a sonotrode head with an area that comes into contact with the solder that consists of a hard material or features such, in particular a hard material layer made of for example tungsten carbide, SiC, diamond, and or/ that a solder is used containing an abrasive, such as Al₂O₃, SiC, Si₃N₄, SiO₂, or that a solder is used containing a component acting as abrasive that precipitates during a lowering of temperature.

6. Method according to at least claim 1,
**characterized in that**,
after the seizing of the solder it is again heated up and smoothed by means of pressurization.

7. Method according to at least claim 1,
**characterized in that**,
during the soldering-on of the solder onto the workpiece an electrical conductor, such as a connecting conductor, is soldered onto the solder, or that after the soldering-on of the solder, in a separate method step by supplying thermal energy, an electrical conductor is soldered onto the solder that was soldered onto the workpiece, or that the solder is soldered onto a solar cell as workpiece in paths or strips for the formation of busbars for the electrically conducting connection with current collectors that are present on the solar cell.

8. Device for the application and soldering-on of a solder in a soldering zone onto a workpiece (12), in particular onto a semiconductor component such as a solar cell, encompassing a soldering supply device (54), a heating device (50) for the solder, an ultrasound sonotrode (58) as well as a transport installation (10) for the transport of the workpiece relative to the heating device as well as also the ultrasound sonotrode,
**characterized in that**,
the transport installation (10) transports the workpiece (12) through the soldering zone in a spring-mounted manner by means of the pressing-on of the same in the direction of the ultrasound sonotrode (58).

9. Device according to claim 8,
**characterized in that**,
the transport installation (10) features a first and second transport element (16, 18) between which the workpiece (12) is fixed in a clamped manner, wherein the first transport element (16) is actively driven and the second transport element (18) is driven by means of frictional engagement with the first transport element or the workpiece or by means of its own additional drive, wherein preferably the first and the second transport elements (16, 18) are endless flat elements or endless round elements such as flat belts or round cords and/or the first and/or the second transport element (16, 18) features two endless flat elements or endless round elements that are spaced apart to each other, and that are guided by guide rollers (29, 30) that originate from a common axis (26), wherein, if necessary, the first transport installation (16) can be driven via a third transport installation (20), via which the workpiece (12) can be delivered to the first and second transport installation (16, 18).

10. Device according to at least claim 8,
**characterized in that**,
the heating device (50) and the ultrasound sonotrode (58) are adjustable as a unit relative to the first transport installation (16) which forms the transport plane of the workpiece (12), wherein, if necessary, the heating device (50) and the ultrasound sonotrode (58) are adjustable relative to one another and to the transport plane.

11. Device according to at least claim 8,
**characterized in that**,
the heating device (50) features a discharge opening (54) that releases molten solder and is aligned toward the transport plane, wherein the ultrasound sonotrode (58), with its sonotrode head (44) that contacts the molten solder, is preferably disposed directly in the area of the discharge opening (54) or is spaced apart from it.

12. Device according to at least claim 8,
**characterized in that**,
the device features at least one gas supply channel (62) that is isolated against the heating device (50) and from which inert gas can be supplied to the soldering zone.

13. Device according to at least claim 8,
**characterized in that**,
the heating device (50) features on the side facing the workpiece at least one sliding runner (46, 48), and can be supported preferably by means of the at least one sliding runner (46, 48) on the workpiece (12) in a sliding manner.

14. Device according to at least claim 8,
**characterized in that**,
by means of a sensor the workpiece (12) and the solder applied to it respectively can be determined, and the ultrasound sonotrode (58) can be adjusted toward the solder depending on the determined values.

15. Device according to at least claim 8,
**characterized in that**,
the area of the ultrasound sonotrode (58) that comes into contact with the solder preferably features a hard material layer made of tungsten carbide, silicon carbide, boron nitride or diamond, and said area of the sonotrode features a width that is equal to or smaller than the width of a molten soldering strip applied onto the workpiece (12).

## Revendications

1. Procédé destiné à appliquer de la brasure sur une pièce d'oeuvre, de préférence sur un composant à semi-conducteurs tel qu'une cellule solaire, sachant que la brasure est brasée sous une température de brasage T_{L} et sous effet ultrasonore au moyen d'une sonotrode, que de plus la brasure est chauffée au moyen d'un dispositif chauffant, appliquée sur la pièce d'oeuvre et brasée sous effet ultrasonore,
**caractérisé en ce**
**que** pendant le brasage, la pièce d'oeuvre est maintenue de manière élastique par pression sur la pièce d'oeuvre en direction de la sonotrode au moyen d'un dispositif transporteur transportant la pièce d'oeuvre.

2. Procédé selon la revendication 1,
**caractérisé en ce**
**qu'**au moyen du dispositif chauffant, la brasure est chauffée à une température T_{L} telle que T_{L} ≥ T_{M}, T_{M} étant égale à la température de fusion de la brasure.

3. Procédé selon au moins la revendication 1,
**caractérisé en ce**
**que** la chaleur requise pour le brasage est transmise à la pièce d'oeuvre par la brasure, sachant que la brasure est en particulier chauffée par le dispositif chauffant, lequel est mis en contact au moins par intermittence avec la pièce d'oeuvre de préférence suivant un mouvement relatif entre la pièce d'oeuvre et le dispositif chauffant, en particulier le long de la pièce d'oeuvre par glissement.

4. Procédé selon au moins la revendication 1,
**caractérisé en ce**
**que** la hauteur de la brasure sur la pièce d'oeuvre est déterminée par la distance entre la tête de sonotrode ou sa pointe et la pièce d'oeuvre et/ou par la quantité de brasure appliquée, et que de préférence l'axe longitudinal de la sonotrode appliquant l'ultrason est orienté par rapport à la normale issue de la pièce d'oeuvre selon un angle α tel que 0° ≤ α ≤ 90°, de préférence 20° ≤ α ≤ 60°.

5. Procédé selon au moins la revendication 1,
**caractérisé en ce**
**que** pour appliquer les vibrations ultrasonores est utilisée une sonotrode avec une tête de sonotrode comprenant une zone entrant en contact avec la brasure, ladite tête étant constituée d'un matériau en matière dure ou en contenant, en particulier d'une couche de matière dure p. ex. en carbure de tungstène, SiC, diamant, et/ou qu'est utilisée une brasure contenant un produit abrasif tel que Al₂O₃, SiC, Si₃N4, SiO₂, ou qu'est utilisée une brasure contenant un composant qui se dégage lorsque la température baisse et agit en tant que produit abrasif.

6. Procédé selon au moins la revendication 1,
**caractérisé en ce**
**qu'**après refroidissement de la brasure, celle-ci est de nouveau chauffée et lissée par application d'une pression.

7. Procédé selon au moins la revendication 1,
**caractérisé en ce**
**que** pendant le brasage de la brasure sur la pièce d'oeuvre, un conducteur électrique, tel qu'une ligne de jonction, est brasé sur la brasure, ou qu'après le brasage de la brasure, dans une étape de procédé distincte, un conducteur électrique est brasé sous apport d'énergie thermique sur la brasure brasée sur la pièce d'oeuvre, ou que sur une cellule solaire en tant que pièce d'oeuvre, la brasure est brasée en pans ou en bandes pour former des barres de bus afin d'établir une liaison électroconductrice avec les collecteurs de courant présents sur la cellule solaire.

8. Dispositif destiné à appliquer et braser une brasure dans une zone de brasage sur une pièce d'oeuvre (12), en particulier sur un composant à semi-conducteurs tel qu'une cellule solaire, comprenant un dispositif d'alimentation en brasure (54), un dispositif chauffant (50) pour la brasure, une sonotrode ultrasonore (58) ainsi qu'un dispositif transporteur (10) pour déplacer la pièce d'oeuvre relativement au dispositif chauffant et à la sonotrode ultrasonore,
**caractérisé en ce**
**que** le dispositif transporteur (10) transporte la pièce d'oeuvre (12) à travers la zone de brasage de manière élastique par pression sur celle-ci en direction de la sonotrode ultrasonore (58).

9. Dispositif selon la revendication 8,
**caractérisé en ce**
**que** le dispositif transporteur (10) présente un premier et un deuxième éléments transporteurs (16, 18) entre lesquels la pièce d'oeuvre (12) est fixée par serrage, le premier élément transporteur (16) étant entraîné activement et le deuxième élément transporteur (18) étant entraîné par frottement avec le premier élément transporteur ou avec la pièce d'oeuvre ou par un propre entraînement supplémentaire, sachant que de préférence le premier et le deuxième éléments transporteurs (16, 18) sont des éléments sans fin plats ou ronds tels que des courroies plates ou des cordons ronds, et/ou que le premier et/ou le deuxième élément(s) transporteur(s) (16, 18) présente(nt) deux éléments sans fin plats ou ronds distants l'une de l'autre qui sont guidés par des poulies de renvoi (29, 30) partant d'un axe commun (26), et que le cas échéant, le premier dispositif transporteur (16) peut être entraîné par un troisième dispositif transporteur (20) au moyen duquel la pièce d'oeuvre (12) peut être amenée au premier et deuxième dispositifs transporteurs (16, 18).

10. Dispositif selon au moins la revendication 8,
**caractérisé en ce**
**que** le dispositif chauffant (50) et la sonotrode ultrasonore (58) en tant qu'unité sont réglables par rapport au premier dispositif transporteur (16) définissant le plan de transport de la pièce d'oeuvre (12), sachant que le cas échéant, le dispositif chauffant (50) et la sonotrode ultrasonore (58) sont réglables entre eux et par rapport au plan de transport.

11. Dispositif selon au moins la revendication 8,
**caractérisé en ce**
**que** le dispositif chauffant (50) présente un orifice de sortie (54) délivrant de la brasure en fusion et orienté sur le plan de transport, sachant que la sonotrode ultrasonore (58) avec sa tête de sonotrode (44) entrant en contact avec la brasure en fusion est de préférence placée directement dans la zone de l'orifice de sortie (54) ou a distance dudit orifice.

12. Dispositif selon au moins la revendication 8,
**caractérisé en ce**
**que** le dispositif présente au moins un conduit d'alimentation en gaz (62) qui est isolé par rapport au dispositif chauffant (50) et au moyen duquel du gaz protecteur peut être amené à la zone de brasage.

13. Dispositif selon au moins la revendication 8,
**caractérisé en ce**
**que** le dispositif chauffant (50) présente du côté de la pièce d'oeuvre au moins un patin (46, 48) et peut s'appuyer sur la pièce d'oeuvre (12) en glissant de préférence par l'intermédiaire dudit au moins un patin (46, 48).

14. Dispositif selon au moins la revendication 8,
**caractérisé en ce**
**que** la pièce d'oeuvre (12) ou la brasure appliquée sur elle peut être mesurée au moyen d'un capteur, et que la sonotrode ultrasonore (58) peut être ajustée sur la brasure en fonction des valeurs déterminées.

15. Dispositif selon au moins la revendication 8,
**caractérisé en ce**
**que** la zone de la sonotrode ultrasonore (58) entrant en contact avec la brasure, et présentant de préférence une couche de matière dure en carbure de tungstène, carbure de silicium, nitrure de bore ou diamant, présente une largeur qui est égale ou inférieure à la largeur d'une bande de brasure en fusion appliquée sur la pièce d'oeuvre (12).
